# EUROPEAN PATENT APPLICATION

(11) **EP 4 687 175 A1**
(43) Date of publication of application: **04.02.2026**
(21) Application number: 24191686.5
(22) Date of filing: 30.07.2024
(51) Int. Cl.: H01M 4/04, H01M 4/1395, H01M 4/40, H01M 4/36, H01M 4/62, H01M 4/66, C23C 16/18, C23C 16/40, C23C 16/455

(54) **MULTILAYER FILM COATED LITHIUM SUBSTRATE, ITS MANUFACTURE AND USE IN SECONDARY BATTERIES**

(71) Applicant: BASF Coatings GmbH, 48165 Münster (DE)
(72) Inventor: Knemeyer, Kristian, 4055 Basel (CH); Cho, Boram, 4054 Basel (CH); Sung, Myung Mo, 137-880 Seoul (KR)
(74) Representative: Rau, Schneck & Hübner Patentanwälte Rechtsanwälte PartGmbB

(57) **Abstract**

The invention relates to a method for preparing a multilayer film, comprising a. providing a lithium metal substrate, b. applying thereon one or more precursors, selected from metal containing inorganic, metal organic and organometallic precursors by gas phase deposition to form an alloy layer, c. depositing thereon an inorganic layer by gas phase deposition comprising applying one or more precursors selected from inorganic, metal organic and organometallic precursors, and applying one or more reactants, and d. depositing thereon an inorganic/organic hybrid layer by gas phase deposition comprising applying one or more precursors selected from inorganic, metal organic and organometallic precursors, and applying one or more organic precursors, whereby an inorganic/organic hybrid multilayer film is formed, and wherein step c. and d. are carried out one or more times to deposit one or more inorganic and inorganic/organic hybrid layers. The invention further relates to a coated metallic substrate and its use.

## Description

The invention relates to a method for preparing a multilayer film on a lithium metal substrate. The invention further relates to a coated metallic substrate. Moreover, the invention relates to a use of a coated metallic substrate in secondary batteries or in solid-state electrolyte batteries.

### Background of the Invention

Lithium metal is a promising anode material for batteries, e.g., rechargeable batteries like secondary batteries or solid-state electrolyte batteries, due to its high specific capacity (3860 mA h g⁻¹), volumetric capacity (2062 mA h cm⁻³), and its low reduction potential (-3.04 V vs standard hydrogen electrode).

However, the use of Li metal anodes in rechargeable batteries in prior art is limited by multiple challenges. Firstly, safety concerns have to be addressed, as during battery charging dendrite formation occurs which can ultimately lead to short circuits and thermal runaways.

Secondly, the cycle life of batteries comprising lithium anodes is limited due to side reactions occurring during the battery charge or discharge steps. In particular, these side reactions lead to Li inventory loss by the formation of "dead lithium" by electrolyte consumption, which results into reduced coulombic efficiency and eventually into battery failure. Examples of Li inventory losses are, e.g., the formation of the aforementioned dendrites or the formation of an uncontrollably grown solid electrolyte interphase (SEI), which grows each charge/discharge cycle.

A thereby formed SEI is nevertheless essential for the charge and discharge processes of the Li anode. Importantly, this interphase layer inhibits further electrolyte degradation while facilitating lithium-ion transport through the layer onto the anode and therefore has a high impact on the long-term cycling of the battery. However, controlling the SEI formation is difficult, due to the spatially and temporally dynamic nature of its formation during the initial charging process and the continual occurring surface.

Thirdly, lithium metal anodes of the prior art exhibit poor air stability, which limits their processibility during battery manufacturing to non-ambient environments.

These challenges can be addressed by the use of electrolyte additives or direct surface modifications to form an artificial SEI in-situ or ex-situ, respectively, whereby the Li loss due to an uncontrollably grown SEI is inhibited and further the surface of the Li electrode can be designed to have a positive impact on Li electrode efficiency. However, SEIs on Li electrodes prepared according to the prior art have limitations in terms of stability, uniformity, and thickness control.

Thus, there is still the need to solve the safety issues, low cycle life and processability limitation to non-ambient environments of lithium metal electrodes within batteries, in particular within solid-state electrolyte batteries and secondary batteries. Sophisticated SEIs formed on lithium electrodes addressing these issues should be in particular able to protect lithium metal by significantly reducing or eliminating dendrite formation as well as side reactions leading to the formation of "dead lithium" and extending the processability of said electrodes, e.g., in ambient environment, while they should also exhibit an increased stability and uniformity themselves compared to SEI of the prior art.

### SUMMARY

The above aims of the present invention were achieved by a method for preparing a multilayer film on a lithium metal substrate, comprising the steps of
a. providing the lithium metal substrate,
b. applying one or more precursors selected from metal containing inorganic precursors, metal organic precursors and organometallic precursors on the metal substrate by gas phase deposition and thereby reacting the one or more precursors with said metal substrate to form a lithium alloy layer on top of the metal substrate, comprising lithium and at least one other metal, and to chemisorb the one or more precursors on top of said lithium alloy layer,
c. depositing an inorganic layer (Lⁱ) on the outmost layer present on the metal substrate by gas phase deposition comprising steps c.1 and c.2, namely
   c.1 if the preceding step is not step b., applying one or more precursors selected from inorganic precursors, metal organic precursors and organometallic precursors on the outmost layer present on the metal substrate, whereby the one or more precursors are chemisorbed on top of said outmost layer, and
   c.2 applying one or more reactants on the outmost layer present on the metal substrate comprising the one or more precursors as chemisorbed in step b. or step c.1 and thereby reacting the one or more reactants with said one or more precursors to form the inorganic layer (Lⁱ),
   and
d. depositing an inorganic/organic hybrid layer (L^{io}) on the outmost layer present on the metal substrate by gas phase deposition comprising steps d.1 and d.2, namely
   d.1 applying one or more precursors selected from inorganic precursors, metal organic precursors and organometallic precursors on the outmost layer present on the metal substrate, whereby the one or more precursors are chemisorbed on top of said outmost layer, and
   d.2 applying one or more organic precursors on the outmost layer present on the metal substrate comprising the one or more precursors as chemisorbed in step d.1 and thereby reacting the one or more organic precursors with said one or more precursors to form the inorganic/organic hybrid layer (L^{io}),
whereby an inorganic/organic hybrid multilayer film is formed, and wherein step c. is carried out one or more times to deposit one or more inorganic layers (Lⁱ) before step d. is carried out and step d. is carried out one or more times to deposit one or more inorganic/organic hybrid layers (L^{io}).

The term "inorganic/organic hybrid multilayer film" in view of the present invention means a multilayer film comprising at least one inorganic layer (Lⁱ) and at least one inorganic/organic hybrid layer (L^{io}), wherein "i" stands for "inorganic" and "io" stands for "inorganic/organic".

In the following the method for preparing a multilayer film coated substrate is also denoted as the "method for preparing a multilayer film coated substrate according to the invention", as the "method for preparing an MLF coated substrate according to the invention" or as the "method according to the invention".

Another object of the present invention is a coated metallic substrate, comprising
a lithium metal substrate (i) comprising a lithium alloy layer on its surface, and
an inorganic/organic hybrid multilayer film (ii), comprising one or more inorganic layers (Lⁱ) and one or more inorganic/organic hybrid layers (L^{io}) and which is bound to the surface of the substrate (i) by one of the one or more inorganic layers (Lⁱ).

In the following the coated metallic substrate is also denoted as the "coated substrate according to the invention", as the "metallic substrate according to the invention", as the "multilayer film coated metallic substrate", as the "multilayer coated metallic substrate" or as the "coated substrate".

Yet another object of the present invention is a use of a coated metallic substrate as defined hereinbefore and hereinafter in secondary batteries or in solid-state electrolyte batteries, characterized in that a lithium metal substrate (i) comprising a lithium alloy layer on its surface is used as electrode and an inorganic/organic hybrid multilayer film (ii) comprising one or more inorganic layers (Lⁱ) and one or more inorganic/organic hybrid layers (L^{io}) functions as a solid electrolyte interphase.

In the following the use of the coated metallic substrate of the invention is also denoted as the "use of the invention."

Further preferred features and embodiments of the invention are disclosed in the dependent claims and the following detailed description.

It has been surprisingly found that the multilayer film coated lithium metal substrate can be prepared with a high planarity, exhibiting a difference between the highest point on the coated surface to the lowest point on the coated surface of less than 100 nm.

It has further been surprisingly found that the multilayer film coated lithium metal substrate is effectively protected against ambient air.

Furthermore, it has been surprisingly found that the multilayer film functions as artificially prepared SEI on the lithium metal substrate when using the multilayer film coated lithium metal substrate as electrode in a rechargeable battery and thus prevents the uncontrolled SEI growth of uncoated lithium metal and also reduces the thereby linked lithium inventory loss.

It has also been surprisingly found that the multilayer film coated lithium metal substrate, when incorporated as electrode material in a rechargeable battery, is a highly stable electrode compared to those of prior art, exhibiting nearly or no dendrite formation nor the formation of "dead" lithium after 1000 h or 1000 cycles of electrochemical cycling.

### DETAILED DESCRIPTION

### Method for preparing a multilayer film coated lithium metal substrate

A first subject-matter of the present invention is a method for preparing a multilayer film on a lithium metal substrate, comprising the steps of
a. providing the lithium metal substrate,
b. applying one or more precursors, preferably exactly one precursor, selected from metal containing inorganic precursors, metal organic precursors and organometallic precursors on the metal substrate by gas phase deposition and thereby reacting the one or more precursors with said metal substrate to form a lithium alloy layer on top of the metal substrate, comprising lithium and at least one other metal, and to chemisorb the one or more precursors on top of said lithium alloy layer,
c. depositing an inorganic layer (Lⁱ) on the outmost layer present on the metal substrate by gas phase deposition comprising steps c.1 and c.2, namely
   c.1 if the preceding step is not step b., applying one or more precursors, preferably exactly one precursor, selected from inorganic precursors, metal organic precursors and organometallic precursors on the outmost layer present on the metal substrate, whereby the one or more precursors are chemisorbed on top of said outmost layer, and
   c.2 applying one or more reactants, preferably exactly one reactant, on the outmost layer present on the metal substrate comprising the one or more precursors as chemisorbed in step b. or step c.1 and thereby reacting the one or more reactants with said one or more precursors to form the inorganic layer (Lⁱ),
   and
d. depositing an inorganic/organic hybrid layer (L^{io}) on the outmost layer present on the metal substrate by gas phase deposition comprising steps d.1 and d.2, namely
   d.1 applying one or more precursors, preferably exactly one precursor, selected from inorganic precursors, metal organic precursors and organometallic precursors on the outmost layer present on the metal substrate, whereby the one or more precursors are chemisorbed on top of said outmost layer, and
   d.2 applying one or more organic precursors, preferably exactly one organic precursor, on the outmost layer present on the metal substrate comprising the one or more precursors as chemisorbed in step d.1 and thereby reacting the one or more organic precursors with said one or more precursors to form the inorganic/organic hybrid layer (L^{io}),
whereby an inorganic/organic hybrid multilayer film is formed, and wherein step c. is carried out one or more times to deposit one or more inorganic layers (Lⁱ) before step d. is carried out and step d. is carried out one or more times to deposit one or more inorganic/organic hybrid layers (L^{io}).

The term "inorganic/organic hybrid multilayer film" in view of the present invention means a multilayer film comprising at least one inorganic layer (Lⁱ) and at least one inorganic/organic hybrid layer (L^{io}), wherein "i" stands for "inorganic" and "io" stands for "inorganic/organic".

The term "applying on the surface" in combination with one or more precursors, organic precursors or reactants means that the respective compounds, if not already gaseous, are brought into the gas phase, preferably by the means of vaporization, and then deposited from the gas phase on the surface of the substrate, whereby said respective compounds chemically react with said surface, e.g., by being chemisorbed and/or by forming an alloy layer, an inorganic layer or an inorganic/organic hybrid layer.

The multilayer film thickness is mostly depending on the number of times step c. and/or step d. were carried out. Preferably, the formed inorganic/organic hybrid multilayer film has a thickness in the range from 0.2 nm to 200 nm, more preferably in the range from 0.3 nm to 100 nm, even more preferably in the range from 0.5 to 50 nm.

In case step c. and/or step d. are carried out more than one time, the thus formed multilayer film contains more than one inorganic layers (Lⁱ) and/or inorganic/organic hybrid layers (L^{io}).

Preferably, after step d. has been carried out one or more times, the multilayer film is denoted as a layer stack ((Lⁱ)ₐ(L^{io})_{b})ₙ(Lⁱ)ₜ, wherein n stands for the number of ((Lⁱ)ₐ(L^{io})_{b}) repetition layers, a for the number of inorganic layers (Lⁱ) within one repetition layer, b for the number of inorganic/organic hybrid layers (L^{io}) within one repetition layer, and t for the number of final inorganic layers, whereby t may be 0. If a is larger than 1, the multiple inorganic layers (Lⁱ) may be described as a combined inorganic layer (Lⁱ)ₐ. The same applies analogously for b, the inorganic/organic hybrid layers (L^{io}) and a combined inorganic/organic hybrid layer (L^{io})_{b}. More preferably, a and b are chosen individually for each different unit n, i.e., for each different repetition layer. The first layer of the multilayer film deposited on the lithium alloy layer is always an inorganic layer (Lⁱ), but the last layer in such stack can either be an inorganic layer (Lⁱ) (t > 0) or an inorganic/organic hybrid layer (L^{io}) (t = 0).

Preferably, step c. and step d. are carried out multiple times so that the formed multilayer film consists of a layer stack ((Lⁱ)ₐ(L^{io})_{b})ₙ(Lⁱ)ₜ, wherein a and b are chosen individually for each different unit n, and a = 1 to 20, b = 1 to 20, n = 1 to 200 and t = 0 to 20, more preferably a = 1 to 15, b = 1 to 15, n = 2 to 100 and t = 0 to 15, even more preferably a = 1 to 10, b = 1 to 10, n = 10 to 50 and t = 0 to 10, and the first of the n Lⁱ layers is deposited on the surface of the lithium alloy layer.

More preferably, within a layer stack ((Lⁱ)ₐ(L^{io})_{b})ₙ(Lⁱ)ₜ, the ratio between a to b, i.e., the ratio between inorganic layers (Lⁱ) to inorganic/organic hybrid layers (L^{io}) within any repetition layer, is in each case in the range from 1:2 to 10:1, even more preferably is in the range from 1:1 to 7:1, most preferably is 5:1, whereby said ratios are described as a:b.

More preferably, within a layer stack ((Lⁱ)ₐ(L^{io})_{b})ₙ(Lⁱ)ₜ, any inorganic layers (Lⁱ) are deposited by atomic layer deposition (ALD) and any inorganic/organic hybrid layers (L^{io}) are deposited by molecular layer deposition (MLD). Combining the ALD with the MLD technique allows the alternating deposition of organic layers and inorganic layers at molecular level (i.e., achieving layer thicknesses of a few nanometers), whereby so called "nanolaminates" may be formed. An ALD/MLD combined method is, e.g., disclosed in WO 2015/188990 A2 and WO 2015/188992 A1. The combination of the ALD with the MLD technique allows to make the inventively prepared multilayer film coatings more flexible, which is advantageous for the electrochemical application of such coatings as they allow to compensate volume expansion during charging and/or discharging processes of the coated anode.

In the following, the steps a. to d. are described in more detail.

### Step a. (Li metal substrate)

In step a., the lithium metal substrate is provided. The lithium metal substrate has a lithium content of at least 98 wt.-%, more preferably of at least 99 wt.-%, even more preferably of at least 99.5 wt.-%, based on the total weight of the substrate. In the following, the lithium metal substrate according to the present invention is also denoted as "lithium substrate".

The lithium metal can have any size and shape. Preferably, the lithium metal is in the shape of a film, a sheet, a tape or a plate. The thickness of the lithium metal can be in a range of from 1 µm to 1 mm, preferably in a range of from 2 µm to 300 µm, more preferably in a range of from 5 µm to 50 µm.

The surface of the lithium metal is preferably of high planarity. The term "high planarity" in the sense of the present invention preferably means that the highest point on the surface of the lithium metal substrate is less than 100 nm higher than the lowest point on the surface, more preferably less than 50 nm. The planarity can be measured with atomic force microscopy, preferably in tapping mode.

### Step b. (lithium alloy layer)

In step b., one or more precursors, preferably exactly one precursor, are applied on the metal substrate by gas phase deposition and thereby reacting the one or more precursors with said metal substrate to form a lithium alloy layer on top of the metal substrate comprising lithium and at least one other metal and to chemisorb the one or more precursors on top of said lithium alloy layer. The one or more precursors are selected from metal containing inorganic precursors, metal organic precursors and organometallic precursors.

In the sense of the present invention, the term "metal organic precursor" means a material comprising a metal wherein said metal is not directly bound by a carbon-metal bond to a carbon atom of an organic moiety but to a heteroatom of a functional group of said organic moiety, e.g., oxide, sulfide or nitride bonds.

In the sense of the present invention, the term "organometallic precursor" means a material comprising a metal wherein said metal is directly bound by a carbon-metal bond to a carbon atom of an organic moiety.

Gas phase deposition methods have in common among others that at least one volatile precursor or vaporized precursor is brought into contact with the surface of a solid substrate. Said at least one precursor consequently reacts with said surface to form a layer, film or to be chemisorbed on top of said surface; however, depending on the precursor, one or more reactants may also be needed to be applied to the surface after the precursor is brought into contact with said surface to start a layer- or film-forming reaction. Preferably, to form the lithium alloy layer no reactant is used.

Preferably, to form the lithium alloy layer, a gas phase deposition method is selected from chemical vapor deposition (CVD) and physical vapor deposition (PVD). Preferably, atomic layer deposition (ALD), a subclass of CVD, is used to form the lithium alloy layer, since ALD enables precise control of layer thickness and layer composition at the atomic scale and thus allows to achieve an excellent thickness control and a highly conformal, well ordered alloy layer.

The gas phase deposition in step b. may be applied in a batch or a continuous (e.g. roll-to-roll) system in vacuum or at atmospheric conditions, whereby, for the inventive method, preferably a continuous system is used and more preferably a continuous roll-to-roll system is used.

Additionally, said continuous systems are able to apply materials, e.g., precursors and reactants, in a temporal or spatial sequence to a substrate, whereby the former in the sense of the present invention preferably means that the substrate is treated by different materials in temporal succession, while the latter means that the substrate is moved through multiple system sections, wherein in each section a different material may be applied. Preferably, a spatial sequence is used for the gas phase deposition of the present invention.

Preferably, the lithium alloy layer formed in step b. comprises lithium and at least one metal selected from Be, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl and Bi, more preferably at least one metal selected from Mg, Al, Si, Ti, V, Mn, Fe, Co, Ni, Cu, Zn, Sn, Ge, In, Zr, Ag, Ir and Pt, wherein said lithium alloy layer is formed by applying one or more precursors, more preferably exactly one precursor, on top of the metal substrate and thereby reacting the one or more precursors with said metal substrate, the one or more precursors comprising said at least one metal and being selected from metal halides, metal hydrides, metal alkoxides, metal cyclopentadienyls, metal alkylamides, metal silylamides, metal amidinates, metal β-diketonates, metal β-ketoesters, metal β-ketoamides and organometallics, more preferably being selected from metal halides, metal alkoxides and organometallics.

Preferably, organometallic precursors suitable to form the Li alloy layer are comprising a metal chosen from the list hereinabove and are further comprising one or more organic groups selected from alkyl groups, e.g., methyl, ethyl, propyl, butyl, iso-propyl, iso-butyl and tert-butyl groups, and ethylenically unsaturated groups, e.g., allyl, vinyl, 1-propenyl and butenyl groups, and are more preferably not comprising any other organic groups.

Preferably, metal halide-precursors comprising a metal chosen from the list hereinabove and which are suitable to form the Li alloy layer further comprise fluorine, chlorine, bromine, iodine or the respective anion of said halogens.

Preferably, metal alkoxide-precursors comprising a metal chosen from the list hereinabove and which are suitable to form the Li alloy layer are selected from methoxide-metal compounds, ethoxide-metal compounds, propoxide-metal compounds, butoxide-metal compounds, iso-propoxide-metal compounds, isobutoxide-metal compounds and tert-butoxide-metal compounds.

Preferably, metal cyclopentadienyl-precursors comprising a metal chosen from the list hereinabove and which are suitable to form the Li alloy layer are selected from cyclopentadienyl-metal compounds, methylcyclopentadienyl-metal compounds, pentamethylcyclopentadienyl-metal compounds and ethylcyclopentadienyl-metal compounds.

Preferably, metal alkylamide-precursors comprising a metal chosen from the list hereinabove and which are suitable to form the Li alloy layer are selected from dimethylamide-metal compounds, ethylmethylamide-metal compounds and diethylamide-metal compounds.

Preferably, metal silylamide-precursors comprising a metal chosen from the list hereinabove and which are suitable to form the Li alloy layer are bis(trimethylsilyl)amide-metal compounds.

Preferably, metal amidinate-precursors comprising a metal chosen from the list hereinabove and which are suitable to form the Li alloy layer are selected from N,N'-diisopropylacetamidinate-metal compounds and N,N'-diisobutylacetamidinate-metal compounds.

Preferably, metal β-diketonate-precursors comprising a metal chosen from the list hereinabove and which are suitable to form the Li alloy layer are selected from acetylacetonate-metal compounds (acac), 2,2,6,6-tetramethyl-3,5-heptanedionato-metal compounds (thd), hexafluoro-acetylacetonato-metal compounds (hfac), octane-2,4-dionato-metal compounds (od), and methoxyethoxy-tetramethylheptanatedionate-metal compounds (methd).

Preferably, precursors which are suitable to form the Li alloy layer have a melting point of below 180 °C, more preferably a melting point of below 150 °C.

Preferably, the thickness of the formed lithium alloy layer is in the range from 10 nm to 10 µm, more preferably is in the range from 50 nm to 4.0 µm, even more preferably is in the range from 0.1 µm to 2.0 µm.

Preferably, step b. is carried out at a temperature in a range from room temperature to 180 °C, more preferably in a range from 60 °C to 150 °C.

The term "room temperature" in the sense of the present invention means 20 °C.

Preferably, step b. is carried out at a pressure in a range from 10⁻⁵ mbar to 5000 mbar, more preferably in a range from 10⁻² mbar to 2500 mbar, even more preferably in a range from 1.0 mbar to 1500 mbar.

Preferably, step b. is carried out for 0.5 ms to 120 min, more preferably for 1.0 ms to 60 min, even more preferably for 10.0 ms to 20 min, most preferably for 100 ms to 5 min. At the end of the reaction time, a fraction of the one or more precursors which has not reacted with the metal substrate to form the lithium alloy layer is chemisorbed on top of the surface of the newly formed alloy layer instead, preferably yielding a homogenous monolayer of said chemisorbed precursors on top of said lithium alloy layer.

Preferably, after step b. has been carried out, excess precursors and by-products are removed, more preferably by either purging with argon or by applying vacuum.

Preferably, the lithium alloy layer is of high planarity.

### Step c. (one or more inorganic layers (Lⁱ))

In step c. an inorganic layer (Lⁱ) is deposited on the outmost layer present on the metal substrate by gas phase deposition, said deposition comprising, if the preceding step is not step b., applying one or more precursors, preferably exactly one precursor, selected from inorganic precursors, metal organic precursors and organometallic precursors, on the outmost layer present on the metal substrate, whereby the one or more precursors are chemisorbed on top of said outmost layer (step c.1), and applying one or more reactants, preferably exactly one reactant, on the outmost layer present on the metal substrate comprising the one or more precursors as chemisorbed in step b. or step c.1 and thereby reacting the one or more reactants with said one or more precursors to form the inorganic layer (Lⁱ) (step c.2). As mentioned hereinabove, step c. can be carried out one or more times to deposit one or more inorganic layers (Lⁱ). The formation of the inorganic layer(s) (Lⁱ) can be achieved by several different gas phase deposition techniques as, e.g., CVD, PVD, and/or their respective subclasses ALD and sputtering. Techniques like PVD and CVD to prepare inorganic layers, e.g., metal oxide layers, are known to one of skill in the art and, e.g., described in US 2013/0034689 A1 and EP 2 692 520 A1. Furthermore, a CVD method to produce such layers is e.g., described in DE 40 35 951 C1 or in CA 2 562 914 A1 and references therein; a PVD method to produce such layers is e.g., described in US 5,900,271 A and references therein; and a sputtering method to produce such layers is e.g., described in US 2004/0005482 A1.

Preferably, any inorganic layer (Lⁱ) is deposited on the metal substrate by gas phase deposition selected from chemical vapor deposition (CVD) and physical vapor deposition (PVD), wherein
the one or more precursors, more preferably the exactly one precursor, in step c.1 are selected from metal halides, metal hydrides, metal alkoxides, metal cyclopentadienyls, metal alkylamides, metal silylamides, metal amidinates, metal β-diketonates, organometallics, phosphate esters, phosphoric acid and oxoacids of phosphorous and/or
the one or more reactants, more preferably the exactly one reactant, in step c.2 comprise an oxygen source, a reducing agent, a sulfur source and/or a nitrogen source.

Preferably, any inorganic layer (Lⁱ) is deposited by ALD, since it is possible by using ALD to step-wise deposit chemically-bound, self-limiting layers with excellent thickness control that are highly conformal, well ordered and dense each with a defined thickness. An ALD method, particularly to produce metal oxide layers is, e.g., disclosed in WO 2011/099858 A1, WO 2015/188990 A2 and WO 2015/188992 A1.

The gas phase deposition in step c. may be applied in a batch or a continuous (e.g. roll-to-roll) system in vacuum or at atmospheric conditions as described hereinbefore, whereby, for the inventive method, preferably a continuous system is used, more preferably a continuous roll-to-roll system is used, even more preferably the same system as already described in step b. is used. Preferably, a spatial sequence is used for the gas phase deposition of the present invention.

In step b., one or more precursors are already chemisorbed on top of the lithium alloy layer. Therefore, step c.1 is not carried out if the preceding step is b. and consequently, by directly carrying out step c.2 after step b., the first inorganic layer (Lⁱ) is formed by reacting the one or more reactants with the one or more precursors applied in step b.

Preferably, precursors suitable in step c.1 are selected from phosphate esters, phosphoric acid, oxoacids of phosphorous, organometallics and the metal comprising precursors of the preferred embodiments of step b. as described hereinbefore, whereby the at least one metal within organometallics and said metal comprising precursors may also be Li.

Preferably, reactants suitable in step c.2 are selected from oxygen, water, ozone, hydrogen peroxide, oxygen plasma, hydrogen, hydrogen plasma, alcohols, hydrogen sulfide, sulfur, diethyl disulfide, nitrogen, ammonia and nitrogen plasma, more preferably are selected from oxygen, water, ozone, hydrogen peroxide, oxygen plasma, and alcohols, even more preferably are selected from oxygen, water and ozone.

Preferably, precursors which are suitable in step c.1 have a melting point of below 180 °C, more preferably a melting point of below 150 °C. The same applies to reactants which are suitable in step c.2.

Preferably, any combination of the above-mentioned precursors and reactants suitable for step c.1 and c.2 may be applied, more preferably exactly one of the above-mentioned precursors and exactly one of the above-mentioned reactants are applied in the respective step to deposit an inorganic layer (Lⁱ). Moreover, to form a stack of inorganic layers such as (Lⁱ)ₐ, the one or more precursors, more preferably the exactly one precursor, in step c.1, but also the one or more reactants, more preferably the exactly one reactant, in step c.2, may be chosen independently for each inorganic layer (Lⁱ) to be deposited, whereby the same also applies to a layer stack such as ((Lⁱ)ₐ(L^{io})_{b})ₙ(Lⁱ)ₜ, the values of n, a, b and t are those as described herein above. Preferably, to deposit any inorganic layer (Lⁱ), the one or more precursors within step c.1 are aluminum or zinc containing precursors, more preferably are organometallic precursors comprising aluminum, and the one or more reactants within step c.2 are oxygen sources, more preferably are selected from oxygen, water, ozone and hydrogen peroxide.

Preferably, step c.1 and c.2 each are carried out at a temperature in a range from room temperature to 180 °C, more preferably in a range from 60 °C to 150 °C.

Preferably, step c.1 and c.2 each are carried out at a pressure in a range from 10⁻⁶ mbar to 5000 mbar, more preferably in a range from 10⁻² mbar to 2500 mbar, even more preferably in a range from 1.0 mbar to 1500 mbar.

Preferably, step c.1 and c.2 each are carried out for 0.5 ms to 120 min, more preferably for 1.0 ms to 60 min, even more preferably for 10.0 ms to 20 min, most preferably for 100 ms to 5 min.

Preferably, after step c.1 and/or step c.2 have been carried out, excess precursors and by-products are removed, more preferably by either purging with argon or by applying vacuum.

Preferably, each inorganic layer (Lⁱ) is of high planarity.

### Step d. (one or more inorganic/organic hybrid layers (L^{io}))

In step d. an inorganic/organic hybrid layer (L^{io}) is deposited on the outmost layer present on the metal substrate by gas phase deposition, said deposition comprising applying one or more precursors, preferably exactly one precursor, selected from inorganic precursors, metal organic precursors and organometallic precursors, on the outmost layer present on the metal substrate, whereby the one or more precursors are chemisorbed on top of said outmost layer (step d.1), and then applying one or more organic precursors, preferably exactly one organic precursor, on the outmost layer present on the metal substrate comprising the one or more precursors as chemisorbed in step d.1 and thereby reacting the one or more organic precursors with said one or more precursors to form the inorganic/organic hybrid layer (L^{io}) (step d.2). As mentioned hereinabove, step d. can be carried out one or more times to deposit one or more inorganic/organic hybrid layers (L^{io}).

Preferably, any inorganic/organic hybrid layer (L^{io}) is deposited on the metal substrate by gas phase deposition, wherein
the one or more precursors, more preferably the exactly one precursor, in step d.1 are selected from metal halides, metal hydrides, metal alkoxides, metal cyclopentadienyls, metal alkylamides, metal silylamides, metal amidinates, metal β-diketonates, organometallics, phosphate esters, phosphoric acid and oxoacids of phosphorous and/or
the one or more organic precursors, more preferably the exactly one organic precursor, in step d.2 are selected from aliphatic and/or aromatic compounds comprising one or more oxygen functionalities, nitrogen functionalities, sulfur functionalities, and/or phosphorus functionalities.

The deposition of the inorganic/organic hybrid layer(s) (L^{io}) can be achieved by several different gas phase deposition techniques as e.g., CVD, molecular layer deposition (MLD) and/or organic (thermal or electron beam) evaporation.

Preferably, any inorganic/organic hybrid layer (L^{io}) is deposited by MLD.

The gas phase deposition in step d. may be applied in a batch or a continuous (e.g. roll-to-roll) system in vacuum or at atmospheric conditions as described hereinbefore, whereby, for the inventive method, preferably a continuous system is used, more preferably a continuous roll-to-roll system is used, even more preferably the same system as already described in step b. and/or step c. is used. Preferably, a spatial sequence is used for the gas phase deposition of the present invention.

Organic precursors used in gas phase deposition methods, in particular the MLD technique, to obtain any inorganic/organic hybrid layer (L^{io}) may have special functional groups able to be chemically-bound to any inorganic layer (Lⁱ) or any inorganic/organic hybrid layer (L^{io}) such as carboxylate, amine, thiol, disulfide, sulfide, phosphate or phosphonate groups, or derivatives thereof, as e.g., described in WO 2015/030297 A1, WO 2015/188990 A2 and WO 2015/188992 A1. Preferably, the one or more organic precursors comprise at least one functional group selected from oxygen functionalities, nitrogen functionalities, sulfur functionalities, phosphorus functionalities and any combinations thereof.

Preferably, precursors suitable in step d.1 are selected from the precursors of the preferred embodiments of step c.1 as described hereinbefore.

Preferably, beside one or more oxygen functionalities, nitrogen functionalities, sulfur functionalities, and/or phosphorus functionalities, the one or more organic precursors used in step d.2 comprise saturated, unsaturated, acyclic, cyclic and/or polycyclic aliphatic constituents, and/or comprise single and/or polycyclic aromatic constituents.

Preferably, the one or more organic precursors comprise 1 to 30 carbon atoms, more preferably comprise 1 to 20 carbon atoms, even more preferably comprise 1 to 12 carbon atoms, most preferably comprise 1 to 8 carbon atoms.

Preferably, any oxygen functionality of the one or more organic precursors is selected from alcohols, aldehydes, esters, ethers, ketones and acids.

Preferably, any nitrogen functionality of the one or more organic precursors is selected from amines, amides, nitro compounds and nitriles.

Preferably, any sulfur functionality of the one or more organic precursors is selected from thiols, sulfides, disulfides, sulfonates, sulfones, sulfoxides, thioamides, thioesters and thioacids.

Preferably, any phosphorus functionality of the one or more organic precursors is selected from organophosphates and phosphines.

Preferably, precursors which are suitable in step d.1 have a melting point of below 180 °C, more preferably a melting point of below 150 °C. The same applies to organic precursors which are suitable in step d.2.

Preferably, any combination of the above-mentioned precursors suitable for step d.1 and d.2 may be applied in the respective step to deposit an inorganic/organic hybrid layer (L^{io}). Moreover, to form a stack of inorganic/organic hybrid layers such as (L^{io})_{b}, the one or more precursors, more preferably the exactly one precursor, in step d.1, but also the one or more organic precursors, more preferably the exactly one organic precursor, in step d.2, may be chosen independently for each inorganic/organic hybrid layer (L^{io}) to be deposited, whereby the same also applies to a layer stack such as ((Lⁱ)ₐ(L^{io})_{b})ₙ(Lⁱ)ₜ, the values of n, a, b and t are those as described herein above.

Preferably, to deposit any inorganic/organic hybrid layer (L^{io}), the one or more precursors within step d.1 are aluminum or zinc containing precursors, more preferably are organometallic precursors comprising aluminum, and the one or more organic precursors within step d.2 comprise at least one sulfur functionality, and/or comprise 1 to 8 carbon atoms.

Preferably, step d.1 and d.2 each are carried out at a temperature in a range from room temperature to 180 °C, more preferably in a range from 60 °C to 150 °C.

Preferably, step d.1 and d.2 each are carried out at a pressure in a range from 10⁻⁶ mbar to 5000 mbar, more preferably in a range from 10⁻² mbar to 2500 mbar, even more preferably in a range from 1.0 mbar to 1500 mbar.

Preferably, step d.1 and d.2 each are carried out for 0.5 ms to 120 min, more preferably for 1.0 ms to 60 min, even more preferably for 10.0 ms to 20 min, most preferably for 100 ms to 5 min.

Preferably, after step d.1 and/or d.2 have been carried out, excess precursors and by-products are removed, more preferably by either purging with argon or by applying vacuum.

Preferably, each inorganic/organic hybrid layer (L^{io}) is of high planarity.

### Coated metallic substrate

Another subject-matter of the present invention is a coated metallic substrate, comprising
a lithium metal substrate (i) comprising a lithium alloy layer on its surface, and an inorganic/organic hybrid multilayer film (ii), comprising one or more inorganic layers (Lⁱ) and one or more inorganic/organic hybrid layers (L^{io}) and which is bound to the surface of the substrate (i) by one of the one or more inorganic layers (Lⁱ).

Preferably, the inorganic/organic hybrid multilayer film has a thickness in the range from 0.2 nm to 200 nm, more preferably in the range from 0.3 nm to 100 nm, even more preferably in the range from 0.5 to 50 nm.

Preferably, the coated metallic substrate is obtainable according to the inventive method described hereinabove.

All preferred embodiments described herein above in connection with the inventive method and in each case preferred embodiments thereof are also preferred embodiments of the inventive coated metallic substrate.

### Use of the coated metallic substrate

A further subject of the present invention is a use of a coated metallic substrate as defined hereinbefore in secondary batteries or in solid-state electrolyte batteries, characterized in that a lithium metal substrate (i) comprising a lithium alloy layer on its surface is used as electrode and an inorganic/organic hybrid multilayer film (ii) comprising one or more inorganic layers (Lⁱ) and one or more inorganic/organic hybrid layers (L^{io}) functions as a solid electrolyte interphase (SEI).

Preferably, the coated metallic substrates can also be used as electrode, more preferably as anode, in other electronic devices, e.g., in lithium-ion batteries (LIB), lithium-sulfur batteries and lithium-air batteries.

Preferably, the inventively used coated Li metal electrode prevents uncontrolled SEI growth, reduces lithium inventory loss and/or reduces dendrite formation and thus reduces safety risks and increases battery cycle life compared to lithium comprising batteries of the prior art.

All preferred embodiments described herein above in connection with the inventive method and the inventive coated metallic substrate and in each case preferred embodiments thereof are also preferred embodiments of the inventive coated metallic substrate.

### EXAMPLES

In the following the invention is described by means of examples.

### Multilayer film preparation

A multilayer film on the surface of a Li metal substrate was prepared by a roll-to-roll process as described in Poodt, P. et al., J. Vac. Sci. Technol. A 2012, 30(1). Three different compounds were used for the gas phase deposition methods: the organometallic precursor trimethyl aluminum (TMA), the reactant ozone and the organic precursor 2,3-dimercaptopropanol (DMP). If not stated otherwise, all gas phase deposition methods were carried out at a temperature in a range of from 60 °C to 150 °C for 1 s to 60 s.

### Li alloy layer formation

A Li metal substrate was provided in a gas phase reaction zone (step a.). For the full duration of the alloy formation process, the pressure of the reaction zone was kept in the range of 1 mbar to 1500 mbar. An ALD method has been used to form the Li alloy layer by applying TMA as precursor (step b.).

TMA was continuously applied to the Li metal substrate, thereby forming an alloy layer with the surface layer of the Li metal substrate. The formed LiAl alloy layer grew in thickness until a thickness of 10 nm to 10 µm was achieved. At the end of the reaction time, TMA which has not reacted with the metal substrate to form the lithium alloy layer was chemisorbed on top of the surface of the newly formed alloy layer instead.

Afterwards, any residuals were removed by applying a stream of argon to the reaction zone at a total reaction zone pressure of 0.4 mbar for 100 s.

### Inorganic layer (Lⁱ) deposition

An ALD method has been used to deposit all the inorganic layers (Lⁱ) (step c.), whereby the ALD method comprised consecutively applying TMA as the precursor in step c.1 and ozone as the reactant in step c.2. The pressure of the reaction zone was set to 1.3 µbar to 13.3 mbar and kept at this pressure range for the full duration of the ALD method.

In step c.1, TMA was continuously applied to the outmost layer present on the Li metal substrate, whereby the TMA was chemisorbed on the outmost layer of the Li metal substrate. As the only exception, step c.1 was omitted if the preceding step was step b. as TMA was already chemisorbed in this case.

Afterwards, any residuals, e.g., not chemisorbed TMA and byproducts, were removed by applying a stream of argon to the reaction zone at a total reaction zone pressure of 0.4 mbar for 100 s.

In step c.2, ozone was continuously applied to the outmost layer present on the Li metal substrate comprising the chemisorbed TMA, thereby forming an inorganic aluminum oxide layer on the surface of the outmost layer of the Li metal substrate.

Afterwards, any residuals, e.g., ozone and byproducts, were removed by applying a stream of argon to the reaction zone at a total reaction zone pressure of 0.4 mbar for 100 s.

Afterwards, the ALD process was repeated multiple times, ending after step c.2 was carried out five times in total and any residuals were removed, yielding an inorganic aluminum oxide layer stack without chemisorbed TMA. The total thickness of the formed inorganic layer stack was 0.7 nm.

### Inorganic/organic hybrid layer (L^{io}) deposition

An MLD method has been used to deposit all the inorganic/organic hybrid layers (L^{io}) (step d.), whereby the MLD method comprised consecutively applying TMA as the precursor in step d.1 and DMP as the organic precursor in step d.2. For step d.1, the pressure of the reaction zone was set to 1.3 µbar to 13.3 mbar and kept at this pressure range for the full duration of said step. For step d.2, the pressure of the reaction zone was set to 1.3 µbar to 1.3 mbar and kept at this pressure range for the full duration of said step.

In step d.1, TMA was continuously applied to the outmost layer present on the Li metal substrate, e.g., the former prepared inorganic aluminum oxide layer, whereby the TMA was chemisorbed on the outmost layer of the Li metal substrate.

Afterwards, any residuals, e.g., not chemisorbed TMA and byproducts, were removed by applying a stream of argon to the reaction zone at a total reaction zone pressure of 0.4 mbar for 100 s.

Then in step d.2, DMP was continuously applied to the outmost layer present on the Li metal substrate comprising the chemisorbed TMA, e.g., the former prepared inorganic aluminum oxide layer, thereby forming an inorganic/organic hybrid aluminum DMP layer on the surface of the outmost layer of the Li metal substrate.

Afterwards, any residuals, e.g., DMP and byproducts, were removed by applying a stream of argon to the reaction zone at a total reaction zone pressure of 0.4 mbar for 600 s.

### Inorganic/organic hybrid multilayer film preparation

By depositing multiple inorganic and inorganic/organic hybrid layers in a specific sequence on the LiAl alloy surface as described hereinbefore, an inorganic/organic hybrid multilayer film was bound to the surface of the LiAl alloy layer on top of the Li metal substrate. The chosen sequence can be described by the layer stack ((Lⁱ)₅(L^{io})₁)₂₆(Lⁱ)₀.

Therefore, after the LiAl alloy layer was formed and in view of the chosen layer stack, 26 sequences of inorganic layer stacks (each comprising five inorganic layers and having a total thickness of 0.7 nm as described hereinbefore) followed by inorganic/organic hybrid layers in alternating order were deposited by ALD and MLD, respectively, yielding an inorganic/organic hybrid multilayer film on the LiAl alloy layer on top of the Li metal substrate with a thickness of 20 nm.

### Multilayer film coated Li metal properties

### Surface examination

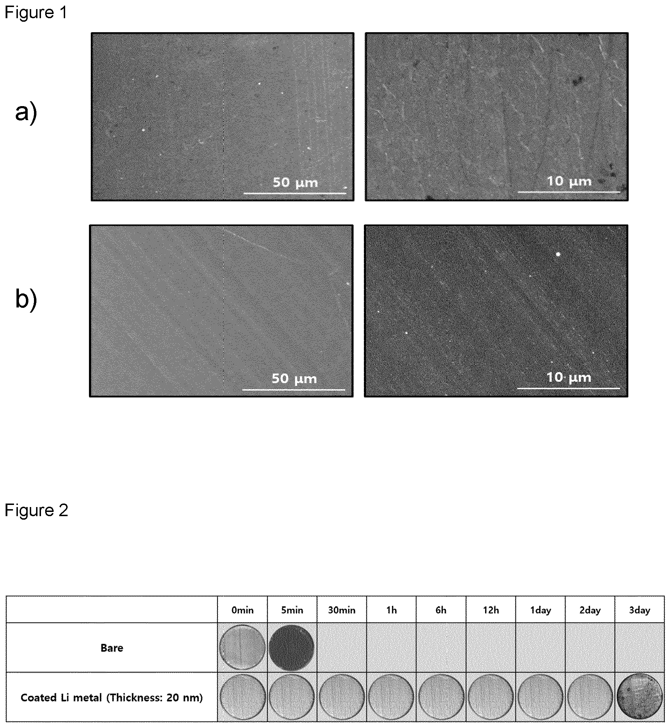

Scanning electron microscopy (SEM) and atomic force microscopy were used to examine the planarity of the surface of the "just prepared" coated Li metal substrate. As comparison, SEM images of an uncoated Li metal reference were also taken. The SEM images are shown in figure 1 a) (uncoated Li metal reference) and b) (multilayer film coated Li metal substrate).

On the surface of the uncoated Li metal reference, narrow, irregular cracks (white lines), narrow throughs/dents (dark lines) and small hills (black spots) were observable, which disrupt the planarity of the surface and are susceptible for unwanted side reactions, e.g., corrosion or dendrite formation. In contrast, it was observed that the multilayer film coated onto the LiAl alloy layer on top of the Li metal substrate did not exhibit the unwanted formations described hereinbefore, demonstrating the high planarity of the multilayer film coated Li metal and that the multilayer film is smoothly applied even on possibly irregular formations of the Li metal substrate surface as e.g., observed for the Li metal reference.

### Air stability test

The multilayer film coated Li metal substrate was tested for its air stability. Said substrate was placed into a box with a camera under inert (argon) atmosphere and a photo was taken. Afterwards, the box was filled with ambient air. A photo was taken after specific amounts of time, i.e., after 5 min, 30 min, 1 h, 6 h, 12 h, 1 d, 2 d and 3 d after exposition to ambient air. As comparison, an uncoated Li metal reference was also analyzed in the same manner. The photos are depicted in figure 2.

After 5 min, the uncoated Li metal reference already turned completely black, indicating that the entire surface has reacted with ambient air. The multilayer film coated material, on the other hand, remained stable for up to 2 d without any visible changes of the coated surface, demonstrating a significant increase in stability while exposed to ambient air.

### Electrochemical cycling tests

### Structure and Method

To demonstrate the suitability of the multilayer coated Li substrate as electrode material, electrochemical cycling tests were carried out using the coated Li substrate as anode material in a secondary battery setup.

Four metal coin cells (C1, C2, CREF1, CREF2) were prepared, each comprising a top cap, a spacer (stainless steel), a (coated) Li metal disc used as anode, a gasket, a separator (Celgard^{®} 2400 monolayer membrane), a cathode, a bottom cap and an electrolyte. The materials used for the anode and cathode of the metal coin cells are indicated in table 1 and further described hereinbelow.

**Table 1**

| Electrode material | C1 | C2 | CREF1 | CREF2 |
|---|---|---|---|---|
| Anode | Inventively coated Li metal disc | Inventively coated Li metal disc | Uncoated Li metal disc | Uncoated Li metal disc |
| Cathode | Inventively coated Li metal disc | Graphite/MoS₂ layer | Uncoated Li metal disc | Graphite/MoS₂ layer |

As cathodes, a Li metal disc (C1, CREF1) or a graphite/MoS₂ layer (C2, CREF2) were used. The graphite/MoS₂ cathode was prepared according to Han, J. et al., J. Alloys Compd., (2021), 862, 158031.

All Li metal discs used as anodes and cathodes (if present) of the metal coin cells C1 and C2 were multilayer film coated prior implementation into the coin cell as described hereinbefore, while, as reference, all Li metal discs in the metal coin cells CREF1 and CREF2 remained uncoated. In each case, the coated or uncoated Li metal discs used as anode or cathode had a diameter of 14 mm and a thickness of 250 µm.

As electrolyte a 1 molar solution of lithium bis(trifluoromethanesulfonyl)imide (LiTFSI) in a 1:1 mixture of 1,3-dioxolane (DMO) and 1,2-dimethoxyethane (DME) was used.

For galvanostatic profiling a current density of 10 mA cm⁻² was applied to a capacity of 10 mA h cm⁻². The charge and discharge speed of the electrochemical cycling were chosen in such a manner that 1 full cycle was completed after 2 h. To simulate second battery cycle life, the electrochemical cycling was carried out for at least 1000 h and up to 2000 h in total. At the end of the electrochemical cycling, the Li metal discs were visually examined.

### Results

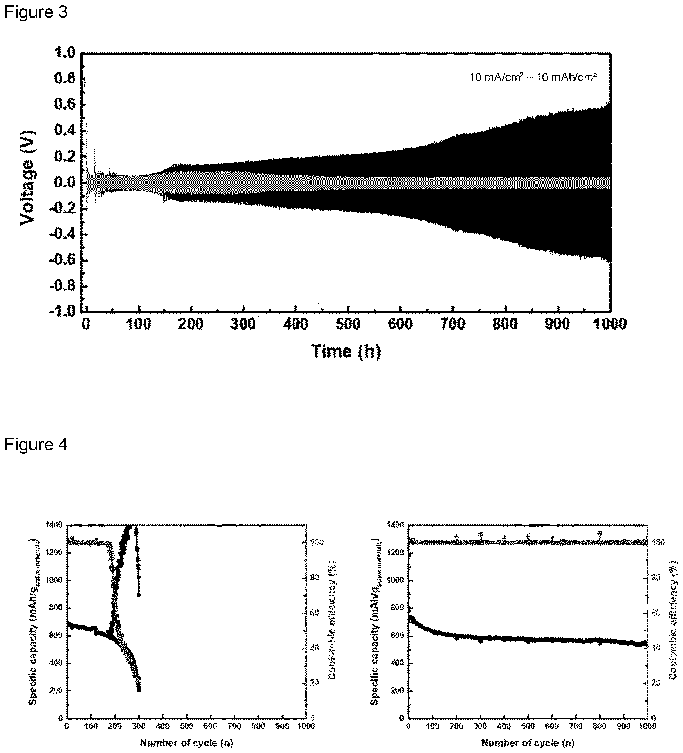

The electrochemical stability and the overpotential of the metal coin cells C1 and CREF1 were determined after 1000 h of electrochemical cycling by the voltage profile shown in figure 3, whereby the voltage profile of the electrochemical cycling test of the metal coin cell C1 is shown in grey and said test of the metal coin cell CREF1 is shown in black. The metal coin cell C1, comprising the multilayer film coated Li metal discs, did not show an increase in overpotential and thus remained stable over the entire cycling period. In contrast, the reference metal coin cell CREF1, comprising uncoated Li metal discs, showed a significant increase in overpotential and a large stability loss.

The metal coin cells C2 and CREF2 were examined for their charge and discharge specific capacities and for their coulombic efficiency as indicated in figure 4, whereby the results of the electrochemical cycling tests of the metal coin cell CREF2 are depicted left and the results of the metal coin cell C2 are depicted right. The charge and discharge specific capacities are shown in black, while the coulombic efficiency is shown in grey. It is pointed out that the charge and discharge specific capacities are nearly identical at the start of the measurements of the metal coin cells C2 and CREF2. The specific capacities and the coulombic efficiency of the metal coin cell C2 remained high over the complete 1000 cycles (i.e., 2000 h) of electrochemical cycling, while after already 200 cycles CREF2 showed first signs of degradation, e.g., by a significant increase of the charge specific capacity and a reduction of the discharge specific capacity, and turned nearly inactive after 300 cycles onwards. As no further coin cell activity was detected during the measurement of CREF2 after 300 cycles, this part was omitted within figure 4 and the measurement stopped after 600 cycles.

Thus, these results demonstrate that the use of the multilayer film coated Li metal disc in metal coin cells C1 and C2 resulted in a significant increase of the electrochemical stability compared to uncoated Li metal discs as used within CREF1 and CREF2.

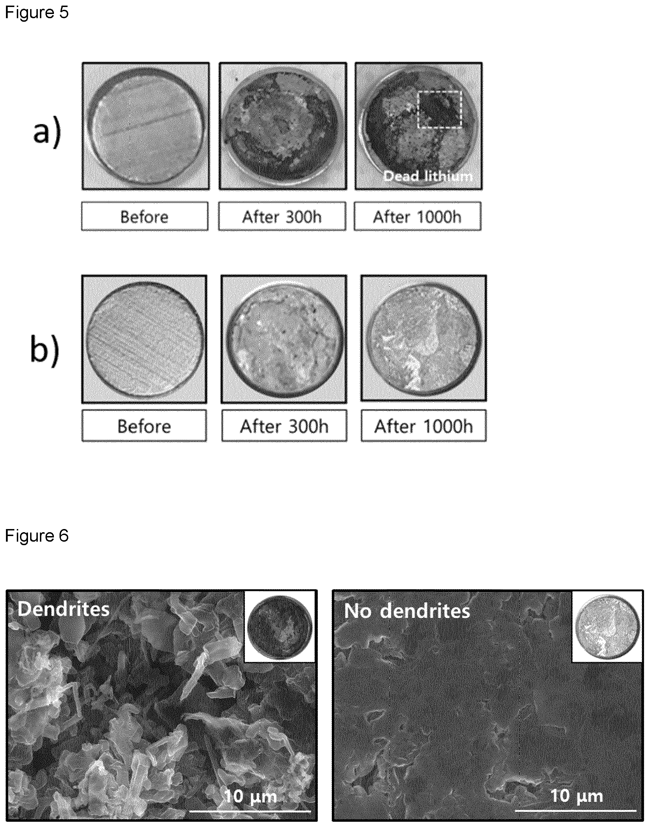

The Li metal discs of the metal coin cells have also been examined in view of the formation of "dead" lithium visually by human and of dendrite formation on the metal surface by SEM. In figure 5, images of an uncoated Li metal reference (row a)) and of the multilayer film coated Li metal (row b)) are shown, in particular before electrochemical cycling (left column), after 300 h of electrochemical cycling (middle column) and after 1000 h of electrochemical cycling (right column). Formation of "dead" lithium is indicated by black spots, in particular within the rectangle. As indicated in figure 5 row a), the uncoated Li metal disc used as anode in the metal coin cell CREF1 showed large black spots after already 300 h of electrochemical cycling, indicating the formation of a large amount of "dead" lithium. These black spots further increased in size after 1000 h of electrochemical cycling. In contrast, as indicated in figure 5 row b), the surface of the multilayer film coated Li metal disc used as anode in the metal coin cell C1 remained mostly unchanged even after 1000 h of electrochemical cycling, indicating that the inorganic/organic hybrid multilayer film functions as SEI on the LiAl alloy layer comprising Li metal substrate. In figure 6, SEM images are shown after 500 cycles (i.e., 1000 h) of electrochemical cycling of the metal coin cell CREF1 comprising an uncoated Li metal disc as anode (left) and of the metal coin cell C1 comprising the multilayer film coated Li metal disc as anode (right). The SEM images showed that after 1000 h of electrochemical cycling dendrite formation only occurred for the uncoated Li metal disc and not for the multilayer film coated Li metal disc.

In summary, the examples of the present invention demonstrate that the inventive multilayer film coated Li metals exhibit a significantly increased air stability and, if used as one or more electrodes within batteries, in particular if used as anode, also exhibit a largely increased electrochemical stability compared to uncoated Li metal even after 2000 h of electrochemical cycling. Furthermore, after 1000 h of electrochemical cycling, the formation of "dead" lithium and dendrites on the surface of the multilayer film coated Li metal disc were remarkably reduced or even fully prevented compared to uncoated Li metal discs, thereby reducing the risk of short circuits and thermal runaways. Thus, the inventive multilayer film coated Li metals are suitable to significantly increase the cycle life of Li metal comprising secondary batteries compared to those of the prior art and may be suited for solid-state electrolyte batteries as well as for liquid electrolyte batteries.

## Claims

1. A method for preparing a multilayer film on a lithium metal substrate, comprising the steps of
a. providing the lithium metal substrate,
b. applying one or more precursors selected from metal containing inorganic precursors, metal organic precursors and organometallic precursors on the metal substrate by gas phase deposition and thereby reacting the one or more precursors with said metal substrate to form a lithium alloy layer on top of the metal substrate, comprising lithium and at least one other metal, and to chemisorb the one or more precursors on top of said lithium alloy layer,
c. depositing an inorganic layer (Lⁱ) on the outmost layer present on the metal substrate by gas phase deposition comprising steps c.1 and c.2, namely
c.1 if the preceding step is not step b., applying one or more precursors selected from inorganic precursors, metal organic precursors and organometallic precursors on the outmost layer present on the metal substrate, whereby the one or more precursors are chemisorbed on top of said outmost layer, and
c.2 applying one or more reactants on the outmost layer present on the metal substrate comprising the one or more precursors as chemisorbed in step b. or step c.1 and thereby reacting the one or more reactants with said one or more precursors to form the inorganic layer (Lⁱ),
and
d. depositing an inorganic/organic hybrid layer (L^{io}) on the outmost layer present on the metal substrate by gas phase deposition comprising steps d.1 and d.2, namely
d.1 applying one or more precursors selected from inorganic precursors, metal organic precursors and organometallic precursors on the outmost layer present on the metal substrate, whereby the one or more precursors are chemisorbed on top of said outmost layer, and
d.2 applying one or more organic precursors on the outmost layer present on the metal substrate comprising the one or more precursors as chemisorbed in step d.1 and thereby reacting the one or more organic precursors with said one or more precursors to form the inorganic/organic hybrid layer (L^{io}),
whereby an inorganic/organic hybrid multilayer film is formed, and wherein step c. is carried out one or more times to deposit one or more inorganic layers (Lⁱ) before step d. is carried out and step d. is carried out one or more times to deposit one or more inorganic/organic hybrid layers (L^{io}).

2. The method for preparing a multilayer film according to claim 1, **characterized in that** after step d. has been carried out one or more times, the multilayer film is denoted as a layer stack ((Lⁱ)ₐ(L^{io})_{b})ₙ(Lⁱ)ₜ, wherein n stands for the number of ((Lⁱ)ₐ(L^{io})_{b}) repetition layers, a for the number of inorganic layers (Lⁱ) within one repetition layer, b for the number of inorganic/organic hybrid layers (L^{io}) within one repetition layer, and t for the number of final inorganic layers, whereby t may be 0.

3. The method for preparing the multilayer film according to claim 2, **characterized in that** step c. and step d. are carried out multiple times so that the formed inorganic/organic hybrid multilayer film consists of a layer stack ((Lⁱ)ₐ(L^{io})_{b})ₙ(Lⁱ)ₜ, wherein a and b are chosen individually for each different unit n, and a = 1 to 20, b = 1 to 20, n = 1 to 200 and t = 0 to 20, and the first of the n Lⁱ layers is deposited on the surface of the lithium alloy layer.

4. The method for preparing the multilayer film according to claim 1 to 3, **characterized in that** the lithium alloy layer formed in step b. comprises lithium and at least one metal selected from Be, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl and Bi, wherein said lithium alloy layer is formed by applying one or more precursors on top of the metal substrate and thereby reacting the one or more precursors with said metal substrate, the one or more precursors comprising said at least one metal and being selected from metal halides, metal hydrides, metal alkoxides, metal cyclopentadienyls, metal alkylamides, metal silylamides, metal amidinates, metal β-diketonates, metal β-ketoesters, metal β-ketoamides and organometallics.

5. The method for preparing the multilayer film according to claim 1 to 4, **characterized in that** the lithium alloy layer formed after step b. comprises lithium and at least one metal selected from Mg, Al, Si, Ti, V, Mn, Fe, Co, Ni, Cu, Zn, Sn, Ge, In, Zr, Ag, Ir and Pt.

6. The method for preparing the multilayer film according any one of claims 1 to 5, **characterized in that** the thickness of the formed lithium alloy layer is in the range from 10 nm to 10 µm.

7. The method for preparing the multilayer film according to any one of claims 1 to 6, **characterized in that** any inorganic layer (Lⁱ) is deposited on the outmost layer of the metal substrate by gas phase deposition selected from chemical vapor deposition (CVD) and physical vapor deposition (PVD), wherein
the one or more precursors in step c.1 are selected from metal halides, metal hydrides, metal alkoxides, metal cyclopentadienyls, metal alkylamides, metal silylamides, metal amidinates, metal β-diketonates, organometallics, phosphate esters, phosphoric acid and oxoacids of phosphorous and/or the one or more reactants in step c.2 comprise an oxygen source, a reducing agent, a sulfur source and/or a nitrogen source.

8. The method for preparing the multilayer film according to any one of claims 1 to 7, **characterized in that** any inorganic layer (Lⁱ) is deposited by atomic layer deposition (ALD).

9. The method for preparing the multilayer film according to any one of claims 1 to 8, **characterized in that** to deposit any inorganic layer (Lⁱ), the one or more precursors within step c.1 are aluminum or zinc containing precursors and the one or more reactants within step c.2 are oxygen sources.

10. The method for preparing the multilayer film according to any one of claims 1 to 9, **characterized in that** any inorganic/organic hybrid layer (L^{io}) is deposited on the outmost layer of the metal substrate by gas phase deposition, wherein
the one or more precursors in step d.1 are selected from metal halides, metal hydrides, metal alkoxides, metal cyclopentadienyls, metal alkylamides, metal silylamides, metal amidinates, metal β-diketonates, organometallics, phosphate esters, phosphoric acid and oxoacids of phosphorous and/or the one or more organic precursors in step d.2 are selected from aliphatic and/or aromatic compounds comprising one or more oxygen functionalities, nitrogen functionalities, sulfur functionalities, and/or phosphorus functionalities.

11. The method for preparing the multilayer film according to any one of claims 1 to 10, **characterized in that** any inorganic/organic hybrid layer (L^{io}) is deposited by molecular layer deposition (MLD).

12. The method for preparing the multilayer film according to any one of claims 1 to 11, **characterized in that** to deposit any inorganic/organic hybrid layer (L^{io}), the one or more precursors within step d.1 are aluminum or zinc containing precursors and the one or more organic precursors within step d.2 comprise at least one sulfur functionality.

13. A coated metallic substrate, comprising
a lithium metal substrate (i) comprising a lithium alloy layer on its surface, and
an inorganic/organic hybrid multilayer film (ii), comprising one or more inorganic layers (Lⁱ) and one or more inorganic/organic hybrid layers (L^{io}) and which is bound to the surface of the substrate (i) by one of the one or more inorganic layers (Lⁱ).

14. The coated metallic substrate according to claim 13, **characterized in that** the inorganic/organic hybrid multilayer film has a thickness in the range from 0.2 nm to 200 nm.

15. The coated metallic substrate according to claim 13 or 14, **characterized in that** it is obtainable according to the method of any one of claims 1 to 12.

16. A use of a coated metallic substrate as defined in any one of claims 13 to 15 in secondary batteries or in solid-state electrolyte batteries, **characterized in that** a lithium metal substrate (i) comprising a lithium alloy layer on its surface is used as electrode and an inorganic/organic hybrid multilayer film (ii) comprising one or more inorganic layers (Lⁱ) and one or more inorganic/organic hybrid layers (L^{io}) functions as a solid electrolyte interphase.
